# EUROPÄISCHE PATENTSCHRIFT

(11) **EP 1 218 202 B1**
(45) Veröffentlichungstag und Bekanntmachung des Hinweises auf die Patenterteilung: **11.06.2003**
(21) Anmeldenummer: 00969338.3
(22) Anmeldetag: 28.09.2000
(51) Int. Cl.: B41M 7/00, B41M 1/34, B41M 1/12, B41M 1/30, B41M 1/28, B41M 1/26, C09D 11/00, C08K 3/08, C08K 5/00, C08G 77/06, H05K 1/09, H01L 21/48, H01B 1/22, H01B 1/20, H01B 1/24, C03B 8/02

(54) **VERFAHREN UND ZUSAMMENSETZUNGEN ZUM BEDRUCKEN VON SUBSTRATEN**
METHOD AND COMPOSITIONS FOR PRINTING SUBSTRATES
PROCEDE ET COMPOSITIONS POUR L'IMPRESSION DE SUBSTRATS

(30) Priorität: 29.09.1999 DE 19946712
(43) Veröffentlichungstag der Anmeldung: 03.07.2002
(73) Patentinhaber: INSTITUT FÜR NEUE MATERIALIEN GEM. GMBH, 66123 Saarbrücken (DE)
(72) Erfinder: KALLEDER, Axel, 66440 Blieskastel (DE); KREUTZER, Rainer, 66740 Saarlouis (DE); MENNIG, Martin, 66287 Quierschied (DE); SCHMIDT, Helmut, 66130 Saarbrücken-Güdingen (DE)
(74) Vertreter: Barz, Peter
(86) Internationale Anmeldenummer: EP0009523
(87) Internationale Veröffentlichungsnummer: WO01023190

(56) Entgegenhaltungen:
- EP-A- 0 263 428
- WO-A-99/00197
- PATENT ABSTRACTS OF JAPAN vol. 1998, no. 13, 30. November 1998 (1998-11-30) & JP 10 204296 A (TEIKOKU CHEM IND CORP LTD), 4. August 1998 (1998-08-04)
- PATENT ABSTRACTS OF JAPAN vol. 018, no. 377 (C-1225), 15. Juli 1994 (1994-07-15) & JP 06 100818 A (SHIN ETSU CHEM CO LTD), 12. April 1994 (1994-04-12)
- PATENT ABSTRACTS OF JAPAN vol. 1998, no. 12, 31. Oktober 1998 (1998-10-31) & JP 10 195280 A (SHIN ETSU CHEM CO LTD), 28. Juli 1998 (1998-07-28)
- PATENT ABSTRACTS OF JAPAN vol. 14, no. 351 (M-1003) [4294], 30. Juli 1990 (1990-07-30) & JP 02 122982 A (DAINIPPON PRINTING COMPANY LIMITED), 10. Mai 1990 (1990-05-10)

## Beschreibung

Die Erfindung betrifft ein Verfahren zur Herstellung von bedruckten Substraten, bei dem man eine spezielle Druckpaste bildmäßig auf ein Substrat aufbringt und durch Wärmebehandlung verdichtet, sowie zur Durchführung dieses Verfahrens geeignete Zusammensetzungen.

Leitfähige Druckpasten, insbesondere leitfähige Siebdruckpasten, zum Bedrucken von Substraten mit leitfähigen Komponenten wie z.B. Leiterbahnen werden nach dem Stand der Technik mit in der Regel niedrig-schmelzenden Glasteilchen, z.B. Glasfritten, unter Beimengung von leitfähigen Metallpulvem hergestellt. Hinzu kommen weitere Komponenten meistens organischer Natur, die das Einstellen einer geeigneten Rheologie, z.B. eines ausgeprägten thixotropen Verhaltens, ermöglichen. Diese Komponenten sind üblicherweise organische Oligomere, z.B. Fischöle, Cellulosen und Cellulosederivate, Polyalkohole oder ähnliche Substanzen. Nach dem Auftragen über ein Druckverfahren, z.B. Siebdruck oder Tampondruck, werden die bedruckten Flächen eingebrannt, wobei das Glas schmilzt und eine Matrix für die perkolierenden Metallteilchen darstellt. Nachteile dieser Methode sind die relativ hohe Einbrenntemperatur von mindestens 600 bis 700°C sowie das Auftreten einer niedrig-viskosen Phase, die bewirkt, daß die Aspektverhältnisse sehr niedrig sind, d.h. die Linien verlaufen aufgrund des Aufschmelzverhaltens des Glases recht breit. Neben den Metallteilchen können solchen Glasteilchen auch andere Partikel beigemengt werden, z.B. Farbpigmente.

EP-A-535374 beschreibt den Einsatz von Silanen als Additive in Siebdruck-Emails. Die Funktion dieser Additive besteht jedoch lediglich in der Fixierung der Dekor-Drucke nach der Trocknung. In den dort beschriebenen Druckpasten werden Glasteilchen eingesetzt.

DE-A-195 20 964 beschreibt die Zusammensetzung eines Sol-Gel-Siebdruck-Materials, in dem Glasfritten und gegebenenfalls Xerogel-Partikel eingesetzt werden. Als Ausgangsmaterialien können Kieselsäureester verwendet werden.

Die erfindungsgemäße Aufgabe bestand darin, ein einfaches und kostengünstiges Verfahren zur Herstellung von bedruckten Substraten unter Verwendung einer Druckpaste bereitzustellen, die schon bei relativ niedrigen Temperaturen zu einer stabilen, fest haftenden bildmäßigen Schicht verdichtet werden kann, welche auch in strukturierter Form z.B. in Form von Leiterbahnen vorliegen kann, und womit Linienbilder mit sehr hoher Auflösung erzeugt werden können. Dabei soll der Einsatz von Schwermetallkomponenten für die Matrix vermieden werden, die bislang zur Erniedrigung der Schmelztemperatur der Matrix erforderlich waren.

Erfindungsgemäß wird die vorstehend genannte Aufgabe durch ein Verfahren zur Herstellung von bedruckten Substraten gelöst, bei dem man eine Druckpaste, umfassend a) ein nach dem Sol-Gel-Verfahren erhaltenes matrixbildendes Kondensat auf Basis von Polyorganosiloxanen und b) ein oder mehrere färbende, lumineszierende, leitfähige und/oder katalytisch wirksame Füllstoffe, bildmäßig auf das Substrat aufbringt und durch eine Wärmebehandlung verdichtet, dadurch gekennzeichnet, daß die Verdichtung bei einer Temperatur durchgeführt wird, die niedriger liegt als die Glasübergangstemperatur der sich bildenden Matrix.

Bei Verwendung von Metallpulvem als Füllstoffen lassen sich im erfindungsgemäßen Verfahren überraschenderweise sehr gut verdichtete Leiterbahnen herstellen, die Voraussetzung für hohe Leitfähigkeit und hohen Perkolationsgrad sind, obwohl dem System nicht wie beim herkömmlichen Einsatz von Glasteilchen bzw. Glasfritten Flußmittel zugegeben werden. Der technische Vorteil dieses Verfahrens besteht darin, daß im Gegensatz zum Stand der Technik ein Aufschmelzen vermieden wird und somit die gedruckten Strukturen nicht auseinanderfließen. Damit wird die Geometrie der gedruckten Linien bzw. Bildmuster in sehr engen Dimensionen gehalten; bei Linienbildem werden z.B. sehr feine Linien mit hoher Kantenschärfe und einem deutlich über dem Stand der Technik liegenden Aspektverhältnis erreicht. Werden anstelle der bevorzugt eingesetzten metallischen Leiter andere Füllstoffe verwendet, so lassen sich damit auch dekorative Muster und Linien oder Flächen durch Bedrucken herstellen. In ähnlicher Weise können geprägte oder extrudierte Strukturen gefertigt werden.

Bei dem erfindungsgemäßen Verfahren können als Substrate beliebige wärmebeständige Materialien eingesetzt werden, beispielsweise Metalle, Legierungen, Kunststoffe, Keramik, Glaskeramik oder Glas. Bevorzugte Substrate sind Keramik, Glaskeramik und Glas. Das Substrat kann auch vorbeschichtet sein. Insbesondere bei Anwendungen, in denen leitfähige Füllstoffe eingesetzt werden, z. B. für die Herstellung von Leiterbahnen, werden bevorzugt leitfähig beschichtete Substrate, insbesondere leitfähig beschichtetes Glas, eingesetzt. Die leitfähig beschichteten Substrate bzw. Glassubstrate sind in der Technik bekannt und im Handel erhältlich. Bei der Beschichtung kann es sich z. B. um Zinnoxid oder Indium-Zinn-Oxid (ITO) handeln. In dem erfindungsgemäßen Verfahren dient das Substrat als Druckträger, auf den das Bildmuster aufgetragen wird.

Als Druckverfahren eignen sich im allgemeinen alle Verfahren, in denen Druckpasten eingesetzt werden. Bevorzugt sind der Siebdruck, Offset-Druck und Tampondruck.

Das erfindungsgemäße Verfahren eignet sich insbesondere zum Bedrucken von Substraten mit leitfähigen Komponenten, wie sie beispielsweise zur Herstellung von Leiterbahnen verwendet werden. Hierfür werden leitfähige Druckpasten eingesetzt, die leitfähige Füllstoffe als Komponente beinhalten. Entsprechende Füllstoffe werden nachstehend näher erläutert werden.

Die Druckpaste wird bildmäßig auf das Substrat aufgebracht. Hierbei bedeutet der Ausdruck "bildmäßig", daß die Druckpaste nicht als vollflächige Schicht aufgetragen wird, sondern in einem beliebigen Muster. Das erfindungsgemäße Verfahren eignet sich wegen der damit erzielbaren hohen Auflösung insbesondere zur Erzeugung von sehr feinen Mustern.

Nachdem die Druckpaste auf das Substrat aufgebracht worden ist, wird sie gegebenenfalls getrocknet, z. B. bei Temperaturen von 80 bis 200°C.

Die Druckpaste wird, vorzugsweise im Anschluß an die Trocknung, durch eine Wärmebehandlung verdichtet. Dabei werden die gedruckten Strukturen nicht aufgeschmolzen, sondern die Wärmebehandlung findet bei einer Temperatur statt, die niedriger liegt als die Glasübergangstemperatur der sich bildenden Matrix. Die Wärmebehandlung findet bevorzugt bei einer Temperatur statt, die mindestens 200°C, bevorzugter mindestens 400°C, niedriger liegt als die Glasübergangstemperatur der sich bildenden Matrix. In Abhängigkeit von der sich bildenden Matrix (z.B. SiO₂) kann die Einbrenntemperatur sogar 600 bis 700°C unter der Glasübergangstemperatur liegen.

Bevorzugt erfolgt die Wärmehandlung bei Temperaturen in einem Bereich von 400°C bis 800°C, bevorzugter 450°C bis 600°C.

Die erfindungsgemäß eingesetzte Druckpaste umfaßt ein nach dem Sol-Gel-Verfahren erhaltenes matrixbildendes Kondensat auf Basis von Polyorganosiloxanen. Das Sol-Gel-Verfahren ist ein in der Technik bekanntes Verfahren. Erfindungsgemäß wird durch partielle Hydrolyse und Polykondensation der hydrolysierbaren Verbindungen, insbesondere hydrolysierbaren Silanen, ein Kondensat erhalten, das noch nicht vollständig kondensiert ist (Vorkondensat). Der Kondensationsgrad liegt z. B. bei 20 bis 80%, vorzugsweise 40 bis 60%. Das so erhaltene flüssige Sol wird zur Herstellung der Druckpaste eingesetzt. Die weitere Kondensation findet bei der späteren Trocknung bzw. Verdichtung statt.

Das matrixbildende Kondensat auf Basis von Polyorganosiloxanen ist beispielsweise erhältlich durch partielle Hydrolyse und Polykondensation von
(A) mindestens einem Organosilan der allgemeinen Formel (I)

   RₙSiX₍₄₋ₙ₎ (I)

   in der die Reste X gleich oder verschieden sind und hydrolysierbare Gruppen oder Hydroxylgruppen bedeuten, R gleich oder verschieden ist und ein nicht hydrolysierbarer Rest ist und n 1, 2 oder 3 ist, oder einem davon abgeleiteten Oligomer,
(B) gegebenenfalls mindestens einem hydrolysierbaren Silan der allgemeinen Formel (II)

   SiX₄ (II)

   in der X wie oben definiert ist, und
(C) gegebenenfalls einer oder mehreren Verbindungen von glas- bzw. keramikbildenden Elementen,

Bei den Organosilanen der Formel (I) und den hydrolysierbaren Silanen der Formel (II) sind die hydrolysierbaren Gruppen X beispielsweise Wasserstoff oder Halogen (F, Cl, Br oder I), Alkoxy (vorzugsweise C₁₋₆-Alkoxy, wie z.B. Methoxy, Ethoxy, n-Propoxy, i-Propoxy und Butoxy), Aryloxy (vorzugsweise C₆₋₁₀-Aryloxy, wie z.B. Phenoxy), Acyloxy (vorzugsweise C₁₋₆-Acyloxy, wie z.B. Acetoxy oder Propionyloxy), Alkylcarbonyl (vorzugsweise C₂₋₇-Alkylcarbonyl, wie z.B. Acetyl), Amino, Monoalkylamino oder Dialkylamino mit vorzugsweise 1 bis 12, insbesondere 1 bis 6 Kohlenstoffatomen.

R ist ein nicht hydrolysierbarer organischer Rest, der gegebenenfalls eine funktionelle Gruppe tragen kann. Beispiele für R sind Alkyl (vorzugsweise C₁₋₆-Alkyl, wie Methyl, Ethyl, n-Propyl, Isopropyl, n-Butyl, s-Butyl und t-Butyl, Pentyl, Hexyl oder Cyclohexyl), Alkenyl (vorzugsweise C₂₋₆-Alkenyl, wie z.B. Vinyl, 1-Propenyl, 2-Propenyl und Butenyl), Alkinyl (vorzugsweise C₂₋₆-Alkinyl, wie z.B. Acetylenyl und Propargyl) und Aryl (vorzugsweise C₆₋₁₀-Aryl, wie z.B. Phenyl und Naphthyl).

Spezielle Beispiele funktionelle Gruppen des Restes R sind die Epoxy-, Hydroxy-, Ether-, Amino-, Monoalkylamino-, Dialkylamino-, Amid-, Carboxy-, Mercapto, Thioether-, Vinyl-, Acryloxy-, Methacryloxy-, Cyano-, Halogen-, Aldehyd-, Alkylcarbonyl-, Sulfonsäure- und Phosphorsäuregruppe. Diese funktionellen Gruppen sind über Alkylen-, Alkenylen- oder Arylen-Brückengruppen, die durch Sauerstoff- oder Schwefelatome oder -NH-Gruppen unterbrochen sein können, an das Siliciumatom gebunden. Die genannten Brückengruppen leiten sich z.B. von den oben genannten Alkyl-, Alkenyl- oder Arylresten ab. Die Reste R enthalten vorzugsweise 1 bis 18, insbesondere 1 bis 8 Kohlenstoffatome. Die genannten Reste R und X können gegebenenfalls einen oder mehrere übliche Substituenten, wie z.B. Halogen oder Alkoxy, aufweisen.

In der allgemeinen Formel (I) hat n den Wert 1, 2 oder 3, vorzugsweise hat n den Wert 1 oder 2.

Besonders bevorzugte hydrolysierbare Silane der Formel (II) sind Tetraalkoxysilane wie Tetraethoxysilan (TEOS). Besonders bevorzugte Organosilane der Formel (I) sind Epoxysilane wie 3-Glycidyloxypropyltrimethoxysilan (GPTS) und Monoalkyltrialkoxysilane wie Methyltriethoxysilan (MTEOS).

Das Kondensat kann vollständig aus einem oder mehreren Organosilanen der Formel (I) hergestellt werden. Sofern diese Organosilane eine funktionelle Gruppe enthalten, ist dies auch eine bevorzugte Ausführungsform. Zur Herstellung des Kondensats werden erfindungsgemäß mindestens 40 Mol.-%, bevorzugt mindestens 60 Mol.-%, des Organosilans der allgemeinen Formel (I) verwendet. Sofern das eingesetzte Organosilan keine funktionellen Gruppen enthält, werden bevorzugt auch hydrolysierbare Silane der Formel (II) eingesetzt. Zur Herstellung des Kondensats können bis zu 60 Mol.-%, bevorzugt nicht mehr als 40 Mol.-%, hydrolysierbare Silane der allgemeinen Formel (II) verwendet werden.

Gegebenenfalls können zur Herstellung des Kondensats zusätzlich eine oder mehrere Verbindungen von glas- bzw. keramikbildenden Elementen eingesetzt werden. Diese sind vorzugsweise im Reaktionsmedium löslich oder dispergierbar. Verwendbar sind z.B. Verbindungen (Halogenide, Alkoxide, Carboxylate, Chelate, etc.) von Lithium, Natrium, Kalium, Rubidium, Cäsium, Beryllium, Magnesium, Calcium, Strontium, Barium, Bor, Aluminium, Titan, Zirkon, Zinn, Zink oder Vanadium.

Die Hydrolyse und Polykondensation wird entweder in Abwesenheit eines Lösungsmittels oder vorzugsweise in einem wäßrigen oder wäßriglorganischen Reaktionsmedium, gegebenenfalls in Gegenwart eines sauren oder basischen Kondensationskatalysators wie HCI, HNO₃ oder NH₃ durchgeführt. Bei Einsatz eines flüssigen Reaktionsmediums sind die Ausgangskomponenten in dem Reaktionsmedium löslich. Als organische Lösungsmittel eignen sich insbesondere mit Wasser mischbare Lösungsmittel, z.B. ein- oder mehrwertige aliphatische Alkohole, Ether, Ester, Ketone, Amide, Sulfoxide und Sulfone.

Gegebenenfalls wird die Hydrolyse und Polykondensation in Gegenwart eines Komplexbildners durchgeführt, z.B. Nitraten, β-Dicarbonylverbindungen (z.B. Acetylacetonaten oder Acetessigsäurester), Carbonsäuren (z.B. Methacrylsäure) oder Carboxylaten (z.B. Acetat, Citrat oder Glykolat), Betainen, Diolen. Diaminen (z.B. DIAMO) oder Kronenether.

In der Druckpaste sind neben dem oben genannten Sol (Vorkondensat) ein oder mehrere färbende, lumineszierende, leitfähige und/oder katalytisch wirksame Füllstoffe enthalten. Es handelt sich dabei bevorzugt um Teilchen in Form eines Pulvers mit Abmessungen im µm-Bereich (z. B. bis zu 30 µm) oder im Sub-µm-Bereich. Es kann sich z. B. um kugelförmige, lamellare oder unregelmäßig geformte Körper handeln. Bei den färbenden Füllstoffen handelt es sich insbesondere um Farbstoffe und Farbpigmente. Die lumineszierenden Füllstoffe umfassen z. B. photo- und elektrolumineszierende Substanzen. Bei den leitfähigen Füllstoffen handelt es sich insbesondere um elektrisch leitende und/oder photoleitfähige Materialien. Katalytisch wirksame Füllstoffe sind z.B. Aluminium-, Chrom- und Titanoxide. In der Druckpaste sind im Fall der leitfähigen Füllstoffe bevorzugt 50 bis 80 Gew.-%, besonders bevorzugt 70 bis 75 Gew.-%, dieser Füllstoffe enthalten. Sofern leitfähige Füllstoffe eingesetzt werden, enthält die auf dem Träger aufgedruckte, verdichtete Druckpaste mindestens 80 Gew.-%, bevorzugt mindestens 95 Gew.-% Füllstoffe. Sofern nur färbende Füllstoffe verwendet werden, können deutlich geringere Mengenanteile, z. B. weniger als 10 Gew.-%, je nach Farbkraft und gewünschter Farbwirkung in der aufzutragenden Druckpaste enthalten sein.

Beispiele für Materialien die als leitfähige Füllstoffe eingesetzt werden können sind Metalle und Metalloxide, aber auch andere Elemente oder Elementverbindungen, z. B. Aluminium, Gold, Silber, Kupfer, Nickel, Chrom, Molybdän, Wolfram, Zinnoxid, Indium-Zinn-Oxid, Bleizirkonattitanat und Graphit.

Als färbende Füllstoffe können anorganische oder organische Substanzen verwendet werden, die auch bei den Verdichtungstemperaturen stabil bleiben. Als temperaturbeständige Farbstoffe eignen sich z.B. Azofarbstoffe wie Methylorange, Alizaringelb oder Kongorot; Dispersionsfarbstoffe wie Disperse Red; Triphenylmethanfarbstoffe wie Malachitgrün, Eosin, Fluoreszein, Aurin und Phenolthalein; Küpenfarbstoffe wie Indigo, Thioindigo und AnthrachinonFarbstoffe; Perylenfarbstoffe sowie Fluoreszenzfarbstoffe wie Fluorescent Brightener 28. Verwendbare Pigmente sind z.B. auf Glimmer basierende Pigmente (Iriodin), Phthalocyanine mit z.B. Cu, Co, Ni, Zn oder Cr als Zentralatom; Rußpigmente und TiO₂.

Die Druckpaste kann gegebenenfalls auch nanoskalige Partikel enthalten, beispielsweise Metallkolloide von Ag, Au, Cu, Pd und Pt, oder Metallverbindungen, z. B. (gegebenenfalls hydratisierte) Oxide wie ZnO, CdO, SiO₂, TiO₂, ZrO₂, CeO₂, SnO₂, Al₂O₃, In₂O₃, La₂O₃, Fe₂O₃, Cr₂O₃, CuO, Cu₂O, Mn₂O₃, Ta₂O₅, Nb₂O₅, V₂O₅, PdO, MoO₃ oder WO₃; Chalkogenide wie beispielsweise Sulfide (z.B. CdS, ZnS, PbS und Ag₂S), Selenide (z.B. GaSe, CdSe und ZnSe) und Telluride (z.B. ZnTe oder CdTe), Halogenide wie AgCI, AgBr, Agl, CuCI, CuBr, Cdl₂ und Pbl₂; Carbide wie CdC₂ oder SiC; Arsenide wie AlAs, GaAs und GeAs; Antimonide wie InSb; Nitride wie BN, AIN, Si₃N₄ und Ti₃N₄; Phosphide wie GaP, InP, Zn₃P₂ und Cd₃P₂; Phosphate, Silikate, Zirkonate, Aluminate, Stannate und die entsprechenden Mischoxide (z.B. solchen mit Perowskitstruktur wie BaTiO₃ und PbTiO₃).

Die nanoskaligen Füllstoffteilchen besitzen im allgemeinen eine Teilchengröße im Bereich von 1 bis 100 nm, vorzugsweise 2 bis 50 nm und besonders bevorzugt 5 bis 20 nm. Diese Materialien können entweder in Form eines Pulvers oder vorzugsweise in Form eines (insbesondere sauer stabilisierten) Sols eingesetzt werden.

Die Menge des färbenden, lumineszierenden und/oder katalytisch wirksamen Füllstoffs richtet sich nach den gewünschten funktionellen Eigenschaften der Beschichtung, z.B. der gewünschten Farbintensität.

In der erfindungsgemäßen Zusammensetzung, die als Druckpaste verwendet werden kann, sind femer ein oder mehrere hochsiedende organische Lösungsmittel mit einem Siedepunkt von mindestens 150°C, bevorzugt mindestens 180°C, besonders bevorzugt mindestens 200°C, in einer Menge von im allgemeinen bis zu 50 Gew.-%, z. B. 1 bis 30 Gew.-% oder 1 bis 10 Gew.-%, enthalten.

Bevorzugte Beispiele für geeignete hochsiedende organische Lösungsmittel sind Di-, Tri-, Tetra-, Penta- oder Hexamere von Monoglycolen, wie z.B. die Di-, Tri-, Tetra-, Penta- oder Hexameren von Ethylen-, Propylen- oder Butylenglycol, und deren Mono- oder Diether, wobei eine oder beide Hydroxylgruppen durch z.B. eine Methoxy-, Ethoxy-, Propoxy- oder Butoxygruppe ersetzt sein können; Terpene, z.B. Terpineol; und Polyole, z.B. 2-Methyl-2,4-pentandiol. Spezielle hochsiedende Lösungsmittel sind Polyethylenglycole und deren Ether, wie Diethylenglycol, Triethylenglycol und Tetraethylenglycol, Diethylenglycoldiethylether, Tetraethylenglycoldimethylether oder Diethylenglycolmonobutylether. Hiervon sind Diethylenglycol, Tetraethylenglycol und Diethylenglycolmonobutylether besonders bevorzugt. Selbstverständlich können auch Mischungen aus zwei oder mehreren dieser Lösungsmittel eingesetzt werden.

In der erfindungsgemäßen Zusammensetzung, die als Druckpaste verwendet werden kann, sind ferner ein oder mehrere Rheologie-Steuerungsmittel in einer Menge von bevorzugt nicht mehr als 5 Gew.-%, z. B. 0,5 bis 2 Gew.-%, enthalten. Das Rheologie-Steuerungsmittel dient zur Einstellung der Strukturviskosität bzw. der Thixotropie der Druckpasten. Dabei können die üblicherweise nach dem Stand der Technik verwendeten Rheologie-Steuerungsmittel eingesetzt werden. Beispiele für derartige Rheologie-Steuerungsmittel sind Fischöle, Cellulosen, Cellulosederivate und Polyalkohole.

Die Zusammensetzung kann zusätzliche für Druckpasten gebräuchliche Additive enthalten. Allerdings enthält die Druckpaste bevorzugt im wesentlichen keine herkömmlicherweise nach dem Stand der Technik eingesetzten Glaspartikel oder Glasfritten, die als Matrixbildner dienen. Die matrixbildende Funktion wird nämlich erfindungsgemäß überraschenderweise durch das eingesetzte (Vor)Kondensat zusätzlich zu seiner Funktion als Bindemittel übernommen. Spezielle Glaspartikel, die nicht als Matrixbildner fungieren, sondern z. B. als Abstandhalter (Spacer) dienen und daher nicht aufgeschmolzen werden, können dagegen in der erfindungsgemäß verwendeten Zusammensetzung enthalten sein.

Die Komponenten werden nach den dem Fachmann bekannten Verfahren zusammengegeben und angepastet, z. B. durch Mischen oder Kneten mit einem Walzenstuhl oder einer Kugelmühle. Durch ebenfalls dem Fachmann bekannte Verfahren wird die für den Druck geeignete Viskosität, z. B. mit Hilfe des Rheologie-Steuerungsmittels, eingestellt.

Das erfindungsgemäße Verfahren und die erfindungsgemäße Zusammensetzung eignen sich insbesondere zur Herstellung von Leiterbahnen, z. B. von sehr feinen Leiterbahnen mit Breiten von unter 100 µm und Höhen bis zu 30 µm auf Glas-, Glaskeramik- und Keramiksubstraten, die insbesondere für die Displaytechnik und für photovoltaische Anwendungen brauchbar sind. Das erfindungsgemäße Verfahren und die erfindungsgemäße Zusammensetzung eignen sich aber auch für dekorative Anwendungen, wobei hohe Auflösungen und damit eine Darstellung sehr feiner Linien möglich ist.

### AUSFÜHRUNGSBEISPIELE

### BEISPIEL 1: Herstellung einer leitfähigen Siebdruckpaste auf Basis von γ-Glycidyloxypropyltrimethoxysilan (GPTS)

473,25 g γ-GPTS werden mit 54,18 g Wasser gemischt und 24 h am Rückfluß erhitzt. Das bei der Hydrolyse bzw. Alkoholyse freigewordene Methanol (116,28 g) wird abrotiert. Das so hergestellte GPTS-Vorhydrolysat wird zur Herstellung einer Druckpaste eingesetzt. 38,0 g Silberpulver (davon 19,0 g lamellares Silberpulver >20 µm, 19,0 g Silberpulver von 1,5 bis 2,5 µm) werden mit 2,375 g des GPTS-Vorhydrolysats gemischt. Dazu gibt man 0,076 g Hydroxypropylcellulose (mittlere Molmasse 100.000 g/mol) gelöst in 5,82 g Tetraethylenglykol.

Die so erhaltene Mischung kann an einem Walzenstuhl oder mit Hilfe einer Kugelmühle angepastet werden. Die Applikation erfolgt unter Anwendung siebdrucküblicher Parameter (z.B. Rakelgeschwindigkeit bis max. 60 cm/s) und Materialien (z.B. Edelstahlsieb 325 mesh, Silikonrakel). Die Verdichtung erfolgt bei einer Temperatur von mehr als 450°C.

### BEISPIEL 2: Herstellung einer Dekorsiebdruckpaste auf Basis von γ-Glycidyloxypropyltrimethoxysilan (GPTS)

Die Herstellung des GPTS-Vorhydrolysats erfolgt wie in Beispiel 1 beschrieben.

Zu 2,37 g dieses Vorhydrolysats gibt man 4,0 g TiO₂ (Merck 808), 0,5 g Tetraethylenglykol sowie zur Thixotropierung 0,02 g Hydroxypropylcellulose (mittlere Molmasse 100.000 g/mol) gelöst in 0,94 g Terpineol.

Das Anpasten und die Applikation erfolgen wie in Beispiel 1.

### BEISPIEL 3: Herstellung einer Siebdruckpaste auf Basis eines organisch modifizierten, anorganischen Bindemittels

Ein Gemisch aus 62,3 g Methyltriethoxysilan (MTEOS) und 21,68 g Tetraethoxysilan (TEOS) wird vorgelegt. Dazu gibt man unter starkem Rühren 35,18 g Kieselsol (Levasil 300/30) und 0,63 ml konzentrierte Salzsäure. Das Gemisch wird 15 min im Eisbad hydrolysiert. Dem so hergestellten Gemisch werden 75,0 g Terpineol zugesetzt. Nach 15 min Rühren wird das im Gemisch enthaltene Ethanol (58,94 g) einrotiert.

Zu 2,5 g dieses Gemisches gibt man 1,3 g Iriodin Silk Red WR2 und 0,1 ml Silikonöl M50. Zur Thixotropierung werden 0,2 g Ethylcellulose (mittlere Molmasse 20.000 g/mol) in 1,8 g Terpineol gelöst, zugegeben.

Die Applikation erfolgt wie in Beispiel 1.

## Patentansprüche

1. Verfahren zur Herstellung von bedruckten Substraten, bei dem man eine Druckpaste, umfassend a) ein nach dem Sol-Gel-Verfahren erhaltenes matrixbildendes Kondensat auf Basis von Polyorganosiloxanen und b) ein oder mehrere färbende, lumineszierende, leitfähige und/oder katalytisch wirksame Füllstoffe, bildmäßig auf das Substrat aufbringt und durch eine Wärmebehandlung verdichtet, **dadurch gekennzeichnet, daß** die Verdichtung bei einer Temperatur durchgeführt wird, die niedriger liegt als die Glasübergangstemperatur der sich bildenden Matrix.

2. Verfahren nach Anspruch 1, **dadurch gekennzeichnet, daß** die Verdichtung bei einer Temperatur durchgeführt wird, die mindestens 200°C niedriger liegt als die Glasübergangstemperatur der sich bildenden Matrix.

3. Verfahren nach Anspruch 1 oder 2, **dadurch gekennzeichnet, daß** die Aufbringung der Druckpaste auf das Substrat durch Siebdruck oder Tampondruck erfolgt.

4. Verfahren nach einem der Ansprüche 1 bis 3, **dadurch gekennzeichnet, daß** als Substrat ein gegebenenfalls leitfähig beschichtetes Glas-, Glaskeramik- oder Keramiksubstrat verwendet wird.

5. Verfahren nach einem der Ansprüche 1 bis 4, **dadurch gekennzeichnet, daß** Leiterbahnen oder Abstandhalter, insbesondere für die Displaytechnik und für photovoltaische Anwendungen, oder dekorative Muster aufgedruckt werden.

6. Zusammensetzung enthaltend
a) ein nach dem Sol-Gel-Verfahren erhaltenes matrixbildendes Kondensat auf Basis von Polyorganosiloxanen, erhältlich durch partielle Hydrolyse und Polykondensation von
(A) mindestens einem Organosilan der allgemeinen Formel (I)
RₙSiX₍₄₋ₙ₎ (I)
in der die Reste X gleich oder verschieden sind und hydrolysierbare Gruppen oder Hydroxylgruppen bedeuten, R gleich oder verschieden ist und ein nicht hydrolysierbarer Rest ist und n 1, 2 oder 3 ist, oder einem davon abgeleiteten Oligomer,
(B) gegebenenfalls mindestens einem hydrolysierbaren Silan der allgemeinen Formel (II)
SiX₄ (II)
in der X wie oben definiert ist, und
(C) gegebenenfalls einer oder mehreren Verbindungen von glas- bzw. keramikbildenden Elementen,
b) ein oder mehrere färbende, lumineszierende, leitfähige und/oder katalytisch wirksame Füllstoffe,
c) ein oder mehrere hochsiedende organische Lösungsmittel mit einem Siedepunkt von mindestens 150°C, und
d) ein oder mehrere Rheologie-Steuerungsmittel.

7. Zusammensetzung nach Anspruch 6, **dadurch gekennzeichnet, daß** zur Herstellung des Kondensats mindestens 40 Mol.-% des Organosilans der allgemeinen Formel (I) verwendet worden sind.

8. Zusammensetzung nach Anspruch 6 oder 7, **dadurch gekennzeichnet, daß** ein oder mehrere Füllstoffe aus der Gruppe der Farbstoffe, Farbpigmente, photo- oder elektrolumineszierenden Substanzen, elektrisch leitenden oder photoleitfähigen Materialien und katalytisch wirksamen Füllstoffe enthalten sind.

9. Zusammensetzung nach einem der Ansprüche 6 bis 8, **dadurch gekennzeichnet, daß** der leitfähige Füllstoff Teilchen von Gold, Silber, Kupfer, Nickel, Wolfram, Molybdän, Zinnoxid, Indium-Zinn-Oxid, Bleizirkonattitanat oder Graphit umfaßt.

10. Zusammensetzung nach einem der Ansprüche 6 bis 9, **dadurch gekennzeichnet, daß** sie im wesentlichen frei von Glasteilchen ist.

## Claims

1. A process for the production of printed substrates, in which a printing paste comprising a) a matrix-forming condensate based on polyorganosiloxanes which is obtained by the sol-gel process, and b) one or more colouring, luminescent, conductive and/or catalytically active fillers, is applied imagewise to the substrate and densified by heat treatment, said process being **characterized in that** densification is carried out at a temperature which is lower than the glass transition temperature of the matrix forming.

2. A process according to Claim 1 wherein the densification is carried out at a temperature which is at least 200°C lower than the glass transition temperature of the matrix forming.

3. A process according to Claim 1 or 2 wherein the printing paste is applied to the substrate by screen printing or pad printing.

4. A process according to one of Claims 1 to 3 wherein the substrate used is a glass, glass-ceramic or ceramic substrate which has optionally been provided with a conductive coating.

5. A process according to one of Claims 1 to 4 wherein conductor tracks or spacers, in particular for display technology and for photovoltaic applications, or decorative patterns are printed on.

6. A composition comprising
a) a matrix-forming condensate based on polyorganosiloxanes which is obtained by the sol-gel process, obtainable by partial hydrolysis and polycondensation of
(A) at least one organosilane of the general formula (I)
RₙSiX₍₄₋ₙ₎ (I)
in which the radicals X are identical or different and are hydrolysable groups or hydroxyl groups, R is identical or different and is a non-hydrolysable radical, and n is 1, 2 or 3, or an oligomer derived therefrom,
(B) optionally at least one hydrolysable silane of the general formula (II)
SiX₄ (II)
in which X is as defined above, and
(C) optionally one or more compounds of glass- or ceramic-forming elements,
b) one or more colouring, luminescent, conductive and/or catalytically active fillers,
c) one or more high-boiling organic solvents having a boiling point of at least 150°C, and
d) one or more rheology control agents.

7. A composition according to Claim 6 wherein the condensate has been prepared using at least 40 mol% of the organosilane of the general formula (I).

8. A composition according to Claim 6 or 7 wherein one or more fillers from the group consisting of dyes, coloured pigments, photo- or electro-luminescent substances, electrically conductive or photoconductive materials and catalytically active fillers are present.

9. A composition according to one of Claims 6 to 8 wherein the conductive filler comprises particles of gold, silver, copper, nickel, tungsten, molybdenum, tin oxide, indium tin oxide, lead zirconate titanate or graphite.

10. A composition according to one of Claims 6 to 9 wherein it is essentially free from glass particles.

## Revendications

1. Procédé de fabrication de substrats imprimés, dans lequel on applique sur un substrat, selon un motif, une pâte d'impression comprenant
a) un produit de condensation à base de polyorganosiloxanes, obtenu par un procédé sol-gel et capable de former une matrice, et
b) un ou plusieurs charges colorantes, luminescentes, conductrices et/ou ayant une activité catalytique,
et l'on procède ensuite à la condensation de ce dépôt par un traitement thermique, **caractérisé par le fait que** la condensation se fait à une température inférieure à la température de transition vitreuse de la matrice en cours de formation.

2. Procédé selon la revendication 1, **caractérisé par le fait que** la condensation se fait à une température inférieure d'au moins 200 °C à la température de transition vitreuse de la matrice en cours de formation.

3. Procédé selon la revendication 1 ou 2, **caractérisé par le fait que** l'application de la pâte d'impression sur le substrat se fait par sérigraphie ou par tampographie.

4. Procédé selon l'une des revendications 1 à 3, **caractérisé par le fait que** l'on utilise, en tant que substrat, un substrat en verre, en vitrocéramique ou en céramique, comportant éventuellement un revêtement conducteur.

5. Procédé selon l'une des revendications 1 à 4, **caractérisé par le fait qu'**il comprend l'impression de lignes conductrices ou d'espaceurs, en particulier pour les techniques de visualisation ou pour les applications photovoltaïques, ou bien l'impression de motifs décoratifs.

6. Composition contenant
a) un produit de condensation à base de polyorganosiloxanes, capable de former une matrice et obtenu selon un procédé sol-gel, susceptible d'être obtenu par hydrolyse partielle et polycondensation
(A) d'au moins un organosilane de formule générale (I)
(I) RₙSiX₍₄₋ₙ₎
dans laquelle chaque X, identique ou différent des autres, représente un groupe hydroxyle ou un groupe hydrolysable, chaque R, identique ou différent des autres, représente un résidu non-hydrolysable et n vaut 1, 2 ou 3, ou un oligomère dérivé d'un tel composé,
(B) au moins un silane hydrolysable de formule générale (II)
(II) SiX₄
dans laquelle X est définie comme ci-dessus, et
(C) éventuellement un ou plusieurs composés d'éléments formant des verres ou des céramiques,
b) un ou plusieurs charges colorantes, luminescentes, conductrices et/ou ayant une activité catalytique,
c) un ou plusieurs solvants organiques non-volatils ayant un point d'ébullition supérieur à 150 °C, et
d) un ou plusieurs agents d'ajustement de la rhéologie.

7. Composition selon la revendication 6, **caractérisée par le fait que** l'on a utilisé pour la préparation du produit de condensation au moins 40 % d'un organosiloxane de formule générale (I).

8. Composition selon la revendication 6 ou 7, **caractérisée par le fait qu'**elle contient une ou plusieurs charges choisies dans le groupe formé par les colorants, les pigments colorés, les substances photo- ou électroluminescentes, les matériaux photo- ou électro-conducteurs et les charges ayant une activité catalytique.

9. Composition selon une des revendications 6 à 8, **caractérisée par le fait que** la charge électro-conductrice comprend des particules d'or, d'argent, de cuivre, le nickel, de tungstène, de molybdène, d'oxyde d'étain, d'oxyde d'indium-étain, de titanate de plomb-zirconium ou de graphite.

10. Composition selon une des revendications 6 à 9, **caractérisée par le fait qu'**elle est essentiellement exempte de particules de verre.
